# FASCICULE DE BREVET EUROPEEN

(11) **EP 2 099 579 B1**
(45) Date de publication et mention de la délivrance du brevet: **07.10.2015**
(21) Numéro de dépôt: 07857531.3
(22) Date de dépôt: 13.12.2007
(51) Int. Cl.: C03C 17/36, C03C 27/00, C04B 37/02, H05K 1/03, H05K 3/34, B23K 35/26, B23K 35/38

(54) **PROCEDE DE SOUDAGE DE COMPOSANTS ELECTRONIQUES**
LÖTVERFAHREN FÜR ELEKTRONISCHE KOMPONENTEN
METHOD FOR SOLDERING ELECTRONIC COMPONENTS

(30) Priorité: 14.12.2006 EP 06126174
(43) Date de publication de la demande: 16.09.2009
(73) Titulaire: AGC Glass Europe, 1348 Louvain-la-Neuve (BE)
(72) Inventeur: LEFEVRE, Hugues, 6040 Jumet (BE); LUIJKX, Antoine, 6040 Jumet (BE)
(74) Mandataire: Bayot, Daisy
(86) Numéro de dépôt international: PCT/EP2007/063884
(87) Numéro de publication internationale: WO 2008/071764

(56) Documents cités:
- EP-A1- 1 080 824
- EP-A2- 0 575 985
- GB-A- 1 409 964
- US-A- 5 071 058

## Description

La présente invention concerne un procédé de soudage de composants électroniques sur un substrat rigide inorganique comprenant l'intervention d'ondes ultrasoniques.

EP 1080824 décrit une soudure sans plomb comprenant de l'étain, du zinc et une petite quantité de titane, convenant pour souder des matériaux oxydés tels que du verre et de la céramique.

Ce document ne divulgue cependant pas le soudage de composants électroniques sur des substrats oxydés.

L'invention remédie à cet inconvénient en fournissant un procédé de soudage de composants électroniques sur un substrat rigide inorganique oxydé comprenant l'intervention d'ondes ultrasoniques.

A cet effet, l'invention concerne un procédé de soudage tel que défini dans la revendication 1.

Ainsi, un tel soudage de composants électroniques sur le substrat oxydé présente l'avantage par rapport aux techniques de collage des composants sur le substrat de ne pas faire intervenir de colle organique qui présente l'inconvénient d'être instable dans le temps.

Le procédé de soudage conforme à l'invention s'adresse à des composants électroniques générant des radiations lumineuses. Par radiations lumineuses, on entend aussi bien celles qui appartiennent au spectre visible que celles qui sont extérieures à celui-ci. Ces radiations peuvent être parfaitement monochromatiques ou, au contraire, se distribuer sur une ou plusieurs bandes de fréquences, contiguës ou non. Ces composants peuvent être choisis parmi les composants dotés de propriétés optoélectroniques ainsi que des composants capables d'émettre des radiations étrangères à celles peuplant le spectre visible, éventuellement avec des radiations appartenant à ce spectre. Ce sont par exemple des diodes électroluminescentes ("LED's") émettant dans le spectre visible, des diodes UV et/ou visible et/ou IR.

Le soudage des composants électroniques réalisé par le procédé selon l'invention se fait sur un substrat rigide inorganique. Par substrat rigide on entend ici un corps plein de forme plate, c'est-à-dire de faible épaisseur comparée à ses autres dimensions et de résistance mécanique aux sollicitations de flexion et de torsion suffisante pour ne pas se déformer sous l'action de sollicitations extérieures. En particulier, les substrats rigides utilisés résistent généralement bien au vent, et aux intempéries en général, y compris la glace et la neige. Le substrat peut se présenter sous la forme d'une plaque rigide constituée d'un matériau inorganique unique ou au contraire être le résultat d'un assemblage de plusieurs feuilles ou plaques du même matériau inorganique ou de matériaux différents collés ou soudés les uns aux autres. Des exemples sont des plaques métalliques recouvertes d'un film d'oxyde, des plaques en céramique, en quartz ou en verre, ainsi que les laminés et placages réalisés avec un ou plusieurs de ces matériaux et dans lesquels un au moins de ces matériaux occupe la surface à souder.

Le procédé de soudage conforme à l'invention se fait sous l'action simultanée d'ondes ultrasoniques. Celles-ci sont des ondes élastiques qui nécessitent un support matériel pour se propager, comme c'est le cas aussi pour les ondes sonores. Leur fréquence se situe généralement dans la gamme allant de 30 à 70 KHz et de préférence, de 40 à 60 KHz. L'intensité du rayonnement ultrasonique dépend de la puissance nominale de l'oscillateur générant les ultrasons. Elle doit être adaptée à la taille des objets à souder. Lorsque les composants électroniques sont des diodes électroluminescentes ("LED's"), des puissances de l'ordre de 10 à 20 W par LED s'avèrent bien adaptées.

Dans le procédé de soudage conforme à l'invention, il est nécessaire d'opérer dans une atmosphère gazeuse comprenant plus de 2% en volume d'oxygène, dans les conditions de pression atmosphérique normales. Il est aussi indispensable que la structure chimique du substrat comprenne des atomes d'oxygène, par exemple dans le réseau solide, cristallin ou amorphe.

Selon l'invention, le procédé nécessite l'utilisation d'une soudure fusible qui est un alliage exempt de plomb comprenant au moins les métaux étain et zinc. Ce procédé présente aussi l'avantage de ne pas requérir la présence simultanée d'un fondant ni d'un décapant et partant d'éviter les problèmes de corrosion et de pollution que ces composés induisent.

Selon un mode de réalisation du procédé conforme à l'invention, l'alliage utilisé pour la soudure comprend aussi au moins un métal sélectionné parmi l'argent, le fer, le cuivre, le nickel et le titane. Plusieurs de ces métaux, voire la totalité d'entre eux peuvent aussi se rencontrer dans l'alliage de soudure. Comme indiqué plus haut, ils influencent la température du changement de phase solide-liquide de l'alliage et la température du procédé de soudage qui en découle. On veillera à sélectionner des alliages particuliers dont la température de fusion est compatible avec une bonne tenue des composants électroniques pendant les quelques dizaines de secondes que dure l'opération de soudage.

Selon un autre mode de réalisation du procédé de soudage conforme à l'invention, éventuellement compatible avec le mode de réalisation précédent, l'alliage de la soudure comprend aussi au moins un métal sélectionné parmi le cérium, l'indium, le silicium, le germanium, le gallium, l'antimoine et l'arsenic.

Un mode de réalisation particulièrement préféré du procédé de soudage selon l'invention est celui dans lequel le substrat rigide inorganique est un verre ou une céramique. Le procédé convient tout particulièrement bien pour souder des composants électroniques sur du verre. Tous les types de verre peuvent être utilisés, comme par exemple, les verres sodo-calciques, les verres au bore, les verres d'optique... Les verres sodo-calciques ont donné d'excellents résultats.

Le procédé selon l'invention convient aussi très bien pour souder des composants électroniques sur des plaques de verre recouvertes d'oxydes métalliques, en particulier ceux recouverts d'une couche d'oxydes électro conducteurs. Un exemple très fréquemment rencontré est celui d'un verre enduit d'une couche d'oxydes métalliques électro conducteurs. Parmi ces couches conductrices, on peut employer les couches de SnO₂ dopées avec du fluor et/ou de l'antimoine, ou encore les couches formées d'un empilage de couches individuelles d'oxydes métalliques comprenant au moins une couche d'argent.

Le procédé de soudage conforme à l'invention requiert aussi, à l'instar de tout procédé de soudage, que la soudure soit fondue par apport de chaleur pendant que les pièces à souder, en l'occurrence ici le composant électronique et le substrat inorganique, sont mis en contact avec cette soudure sous l'influence du champ de rayonnement d'ondes ultrasoniques. Les soudures étant généralement des alliages ou des mélanges eutectiques, chaque composition de ces soudures présente un point de fusion ou, tout au moins une plage étroite de températures dans lesquelles la fusion survient. L'apport d'énergie calorifique a pour but de fournir la chaleur latente de fusion nécessaire pour que la soudure se maintienne dans son état de changement de phase solide en phase liquide. Généralement, ces températures se situent bien en-dessous de la température de fusion du matériau constituant le support inorganique. Des températures de soudures allant de 100 °C environ jusqu'aux alentours de 500 °C peuvent se rencontrer, en fonction de la nature particulière de l'eutectique.

Selon cette technique, l'application simultanée des ondes ultrasoniques et de la chaleur peut être réalisée au moyen d'une tige métallique terminée par un embout en forme de pointe ou de biseau et animée de vibrations à fréquence ultrasonique, la tige étant chauffée par un enroulement d'une résistance électrique chauffante à sa périphérie.

## Revendications

1. Procédé de soudage de composants électroniques sur un substrat rigide inorganique comprenant l'intervention d'ondes ultrasoniques, **caractérisé en ce qu'**on travaille dans une atmosphère gazeuse comprenant plus de 2% en volume d'oxygène, que la structure chimique du substrat comprend des atomes d'oxygène et que la soudure est un alliage exempt de plomb qui comprend au moins les métaux étain et zinc et **en ce que** le substrat frigide inorganique est un verre recouvert d'oxydes métalliques électro conducteurs.

2. Procédé de soudage selon la revendication précédente, **caractérisé en ce que** l'alliage de la soudure comprend aussi au moins un métal sélectionné parmi l'argent, le fer, le cuivre, le nickel et le titane.

3. Procédé de soudage selon une quelconque des revendications précédentes, **caractérisé en ce que** l'alliage de la soudure comprend aussi au moins un métal sélectionné parmi le cérium, l'indium, le silicium, le germanium, le gallium, l'antimoine et l'arsenic.

4. Procédé de soudage selon la revendication précédente, **caractérisé en ce que** les oxydes métalliques électro conducteurs sont une couche de SnO₂ dopée avec du fluor et/ou de l'antimoine.

5. Procédé de soudage selon la revendication 1, **caractérisé en ce que** les oxydes métalliques électro conducteurs sont une couche d'un empilage de couches individuelles d'oxydes métalliques comprenant au moins une couche d'argent.

6. Procédé de soudage selon une quelconque des revendications précédentes, **caractérisé en ce qu'**on applique simultanément les ondes ultrasoniques et de la chaleur pour fondre la soudure et l'accrocher par liaison chimique avec le verre ou la couche électro conductrice d'une part et avec les composants électroniques, d'autre part.

7. Procédé de soudage selon la revendication précédente, **caractérisé en ce que** l'application simultanée des ondes ultrasoniques et de la chaleur est réalisée au moyen d'une tige métallique terminée par un embout en forme de pointe ou de biseau et animée de vibrations à fréquence ultrasonique, la tige étant chauffée par un enroulement d'une résistance électrique chauffante à sa périphérie.

8. Procédé de soudage selon une quelconque des revendications précédentes, **caractérisé en ce que** les composants électroniques sont des diodes électroluminescentes.

## Patentansprüche

1. Verfahren zum Löten elektronischer Bauteile auf einem anorganischen starren Substrat, das den Einsatz von Ultraschallwellen enthält, **dadurch gekennzeichnet, dass** in einer Gasatmosphäre gearbeitet wird, die mehr als 2 Vol.-% Sauerstoff enthält, dass die chemische Struktur des Substrats Sauerstoffatome enthält und dass das Lötmittel eine bleifreie Legierung ist, die wenigstens die Metalle Zinn und Zink enthält, und dass das anorganische starre Substrat ein Glas ist, das mit elektrisch leitenden Metalloxiden überzogen ist.

2. Lötverfahren nach dem vorhergehenden Anspruch, **dadurch gekennzeichnet, dass** die Legierung des Lötmittels außerdem wenigstens ein Metall enthält, das aus Silber, Eisen, Kupfer, Nickel und Titan ausgewählt ist.

3. Lötverfahren nach einem der vorhergehenden Ansprüche, **dadurch gekennzeichnet, dass** die Legierung des Lötmittels außerdem wenigstens ein Metall enthält, das aus Cerium, Indium, Silicium, Germanium, Gallium, Antimon und Arsen ausgewählt ist.

4. Lötverfahren nach dem vorhergehenden Anspruch, **dadurch gekennzeichnet, dass** die elektrisch leitenden Metalloxide eine Schicht aus SnO₂ sind, die mit Fluor und/oder Antimon dotiert ist.

5. Lötverfahren nach Anspruch 1, **dadurch gekennzeichnet, dass** die elektrisch leitenden Metalloxide eine Schicht aus einem Stapel einzelner Schichten aus Metalloxiden, die wenigstens eine Silberschicht enthalten, sind.

6. Lötverfahren nach einem der vorhergehenden Ansprüche, **dadurch gekennzeichnet, dass** gleichzeitig Ultraschallwellen und Wärme angewendet werden, um das Lötmittel zu schmelzen und um es durch chemische Verbindung mit dem Glas oder mit der elektrisch leitenden Schicht einerseits und mit den elektronischen Bauteilen andererseits zu verhaken.

7. Lötverfahren nach dem vorhergehenden Anspruch, **dadurch gekennzeichnet, dass** die gleichzeitige Anwendung von Ultraschallwellen und von Wärme mittels eines Metallstifts, der in einer Spitze oder einer Schrägkante endet und zu Schwingungen mit Ultraschallfrequenz angetrieben wird, ausgeführt wird, wobei der Stift durch Wickeln eines elektrischen Heizwiderstands um seinen Umfang beheizt wird.

8. Lötverfahren nach einem der vorhergehenden Ansprüche, **dadurch gekennzeichnet, dass** die elektronischen Bauteile Leuchtdioden sind.

## Claims

1. Method of soldering electronic components to an inorganic rigid substrate involving the use of ultrasonic waves, **characterized in that** the work is carried out in a gaseous atmosphere containing more than 2% oxygen by volume, **in that** the chemical structure of the substrate includes oxygen atoms and **in that** the solder is a lead-free alloy that comprises at least the metals tin and zinc and **in that** the inorganic rigid substrate is a glass covered with electrically conductive metal oxides.

2. Soldering method according to the preceding claim, **characterized in that** the alloy of the solder also comprises at least one metal selected from silver, iron, copper, nickel and titanium.

3. Soldering method according to any one of the preceding claims, **characterized in that** the alloy of the solder also comprises at least one metal selected from cerium, indium, silicon, germanium, gallium, antimony and arsenic.

4. Soldering method according to the preceding claim, **characterized in that** the electrically conductive metal oxides are a layer of fluorine-doped and/or antimony-doped SnO₂.

5. Soldering method according to Claim 1, **characterized in that** the electrically conductive metal oxides are a layer of a stack of individual layers of metal oxides comprising at least one silver layer.

6. Soldering method according to any one of the preceding claims, **characterized in that** the ultrasonic waves and heat are applied simultaneously in order to melt the solder and attach it by chemical bonding to the glass or the electrically conductive layer on the one hand, and to the electronic components on the other.

7. Soldering method according to the preceding claim, **characterized in that** the simultaneous application of ultrasonic waves and heat is carried out by means of a metal rod terminating in an end-piece of pointed or beveled shape, which undergoes vibrations at ultrasonic frequency, the rod being heated by winding an electrical resistance heating element around its periphery.

8. Soldering method according to any one of the preceding claims, **characterized in that** the electronic components are light-emitting diodes.
